# EUROPEAN PATENT APPLICATION

(11) **EP 1 484 801 A2**
(43) Date of publication of application: **08.12.2004**
(21) Application number: 04012927.2
(22) Date of filing: 01.06.2004
(51) Int. Cl.: H01L 31/05

(54) **Solar battery module and manufacturing method thereof**

(30) Priority: 04.06.2003 JP 2003159409
(71) Applicant: Sharp Kabushiki Kaisha, Osaka-shi, Osaka 545-8522 (JP)
(72) Inventor: Nishikawa, Shigeaki, Kashiba-shi, Nara 639-0226 (JP); Yoshioka, Hideki, Nara-shi, Nara 630-8014 (JP); Suzuki, Yuji, Shiki-gun, Nara 636-0312 (JP)
(74) Representative: Müller - Hoffmann & Partner

(57) **Abstract**

A solar battery module comprising: a plurality of solar battery cells each including a crystalline semiconductor substrate; and a wiring member that connects the solar battery cells to one another, wherein the wiring member contains a substance having a linear expansion coefficient closer to that of the substrate constituting each of the solar battery cells than Cu.

## Description

### BACKGROUND OF THE INVENTION

### Field of the Invention

The present invention relates to a solar battery module and a manufacturing method thereof. More specifically, the present invention relates to a solar battery module in which solar battery cells that constitute the solar battery module are connected to one another by a wiring member having specific characteristics, and a manufacturing method thereof.

### Description of the Related Art

A typical crystalline solar battery cell has a light reception surface, a flat shape, and a structure in that electrodes are formed on the light reception surface (front surface) and a surface opposite to the light reception surface (hereinafter, the opposite surface will be referred to as "rear surface"). A conductor is connected to the respective electrodes from an outside of the solar battery cell by a solder, a paste or the like, and is used as positive and negative electrode terminals. The conductor is normally used in a linear form so as to minimize an area for covering the light reception surface.

If a solar battery module is to be manufactured, pluralities of solar battery cells are connected either in series or in parallel according to required electric characteristics such as a voltage or a current. Therefore, the conductor is used while having a larger length than a length of each edge of the solar battery cell. If the solar battery cells are connected in series, for example, the conductor connected to the light reception surface of one of two adjacent cells is made long enough to be directly connected to the rear surface of the other cell.

Following an increase in size of the solar battery module, a surface area of the solar battery cells is increased per se and the number of the serially connected solar battery cells increases. Generally, each solar battery cell is rectangular so as to facilitate handling the cell in manufacturing steps. In addition, each electrode is generally formed at a position at which the electrode can substantially quarter a rectangular area of the solar battery cell laterally symmetrically and parallel to one edge of the cell. With this configuration, when the solar battery cells are connected in series as described above, the two electrodes can stably fix the two adjacent solar battery cells, respectively.

According to the conventional technique, a Cu wire coated with a solder (hereinafter, referred to as "inter-connector") is used as a wiring member used to connect the solar battery cells to one another as described above (Japanese Unexamined Utility Model Publication No. HEI 3(1991)-81649). In a step of connecting the solar battery cells to the inter-connector, that is, in a wiring step, electrode parts of each solar battery cell or the inter-connector is heated, thereby melting a solder coated onto a surface of the inter-connector, and the solder is solidified by radiating a heat or cooling the solder. As a heating method, various methods including a method for applying the heat to a connected part while the inter-connector is temporarily fixed at a predetermined position, and a method for heating the connected part by a hot air are used. Further, a method is used for applying the heat from the rear surface of the solar battery cell until a surface temperature of the solar battery cell is close to a solder melting temperature by using a heat plate, and for connecting the inter-connector to the solar battery cell.

According to the conventional technique, the inter-connector mainly containing Cu is mainly used as the wiring member. A linear expansion coefficient of the wiring member is considered to be almost 16.7 (× 10⁻⁶/°C) since the main material of the inter-connector is Cu. If the crystalline solar battery cell mainly contains silicon, a linear expansion coefficient of the cell is almost 2.33 (× 10⁻⁶/°C). During the connection of the inter-connector to the solar battery cell, both the wiring member and the solar battery cell (hereinafter, referred to as "both members") are heated. At this time, the both members temporarily expand according to their respective linear expansion coefficients. Thereafter, if the both members are connected to each other by melting the solder, a spontaneous heat radiation or a forced cooling step such as a blasting is executed. If the molten solder is solidified in this step, the wiring member is firmly connected and fixed to the solar battery cell, thus finishing the wiring step.

The both members, which are kept to temporarily expand while being heated, start contracting into ordinary-temperature states according to their respective linear expansion coefficients in a cooling step. As can be understood from their respective physical property values, the both members greatly differ in contraction coefficient. In other words, a physical force (a strain) caused by contraction of the inter-connector is applied to the electrode parts connected to the inter-connector which is expanding. If this force exceeds a critical strength of the solar battery cell, a defect such as fracture, cracking, or the like occurs to the solar battery cell. Since the solar battery cell is the most expensive component among the constituent components of the solar battery module, it is important to suppress occurrence of the defect resulting from this breakage.

Furthermore, according to the conventional technique, it is regarded natural to connect the both members by the solder after superimposing the inter-connector on an electrode pattern on the light reception surface of the solar battery cell in the wiring step. For this reason, if the wiring step is automated, the automation is performed so as to be adapted to this concept. That is, according to the conventional technique, an electrode pattern part is locally heated. As a result, the heat concentrates on the inter-connector having the high linear expansion coefficient, and the influence of the strain disadvantageously grows.

With the heating method using the heat plate, the heat is conducted with the rear surface of the solar battery cell as a starting point. As a result, the rear surface expands more greatly than the light reception surface, so that the solar battery cell itself is disadvantageously warped. This disadvantage may not be regarded so serious for a thick solar battery cell. However, following the recent technical improvement and reduction in cost of each component, the solar battery cell is made thinner. Accordingly, this disadvantage influences characteristics of the solar battery module more conspicuously.

If an operation progresses while the solar battery cell which should be flat is warped, the solar battery cell exceeds a spatial limitation in a flow of steps, and an irregularity occurs during transport. Thus, various abnormalities including deterioration of accuracy for a wiring position occur. These abnormalities, in turn, cause occurrence of a physical defect on a line and an inferior quality in the following steps. That is, it is required to achieve several improvements in the constituent components themselves, the heating method for melting the solder in the wiring step, and the like. The achievement of these improvements is one of the objects that should be attained.

### SUMMARY OF THE INVENTION

The present invention provides a solar battery module comprising: a plurality of solar battery cells each including a crystalline semiconductor substrate; and a wiring member that connects the solar battery cells to one another, wherein the wiring member contains a first substance having a linear expansion coefficient closer to that of the substrate constituting each of the solar battery cells than Cu.

The present invention also provides a manufacturing method of the solar battery module, comprising the steps of: heating all of a plurality of solar battery cells in a furnace; and connecting the solar battery cells to one another by a wiring member while the solar battery cells accumulate a heat.

These and other objects of the present application will become more readily apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

### BRIEF DESCRIPTION OF THE DRAWINGS

Fig. 1 is a schematic cross-sectional view of a wiring member according to a first embodiment of the present invention in a direction perpendicular to a current flow direction.
Fig. 2 is a schematic cross-sectional view of a wiring member according to a second embodiment of the present invention in a direction perpendicular to a current flow direction.
Fig. 3 is a schematic cross-sectional view of a wiring member according to a third embodiment of the present invention in a direction perpendicular to a current flow direction.
Figs. 4A and 4B are a schematic cross-sectional view of a wiring member according to a fourth embodiment of the present invention in a direction perpendicular to a current flow direction.
Fig. 5 is a schematic cross-sectional view of a wiring member according to a fifth embodiment of the present invention in a direction perpendicular to a current flow direction.
Fig. 6 is a schematic cross-sectional view of a wiring member according to a sixth embodiment of the present invention in a direction perpendicular to a current flow direction.
Fig. 7 is a schematic cross-sectional view of a wiring member according to a seventh embodiment of the present invention in a direction perpendicular to a current flow direction.

### DETAILED DESCRIPTION OF THE INVENTION

The difference in linear expansion coefficient between the conventionally used inter-connector mainly containing Cu and the crystalline solar battery cell mainly containing silicon causes a physical breakage of the solar battery cell resulting from a strain applied thereto during the wiring step. The present inventors found that if the first substance having the linear expansion coefficient closer to that of the crystalline substrate, that constitutes the solar battery cell and mainly contains silicon, than Cu is included in the wiring member, the physical breakage can be prevented, and thus reached the present invention. More specifically, according to the present invention, it is possible to provide the wiring member having a smaller strain relative to a load of heating and cooling in the wiring step and capable of reducing occurrence of the cracking of the solar battery cell.

Examples of the other crystalline semiconductor substrate may include a germanium substrate, a GaAs substrate, a GaSb substrate and the like.

In the solar battery module according to the present invention, the first substance is not particularly limited as long as it satisfies conditions of the linear expansion coefficient. Specifically, the linear expansion coefficient of Cu is about 16.7 × 10⁻⁶/°C and that of the substrate (e.g., silicon substrate) constituting the solar battery cell is about 2.33 × 10⁻⁶/°C. Examples of the substance that satisfies the conditions may include metals such as Ti (linear expansion coefficient: about 8.41 × 10⁻⁶/°C), W (linear expansion coefficient: about 4.6 × 10⁻⁶/°C) and Mo (linear expansion coefficient: about 4.9 × 10⁻⁶/°C), and alloys such as Invar (linear expansion coefficient: about 1.2 × 10⁻⁶/°C, Trademark for the ferronickel) and Kovar (linear expansion coefficient: about 6.7 × 10⁻⁶/°C). Needless to say, if a material equal in linear expansion coefficient to the substrate is present, it is not at all necessary to consider the influence of the strain caused by heating and a greater effect can be achieved. It is noted that Invar is the alloy containing 64% of iron and 36% of nickel as well as manganese and carbon in trace amounts, has an electric resistance of about 80 x 10 µΩmm, a density about 8 and a melting point about 1500°C. It is noted that Kovar is the alloy containing 53.8% of iron, 29% of nickel and 17% cobalt as well as manganese in trace amounts.

Further, the first substance is used in the wiring member, i.e., used in the conductor for carrying a current. It is therefore preferable that the first substance has the electric resistance corresponding to an electric resistance of Cu. The electric resistance of Cu is 1.72 × 10 µΩmm. Specifically, examples of the first substance may include metals such as Ti (electric resistance: 4.2 × 10 µΩmm) and Mo (electric resistance: 5.2 × 10 µΩmm). However, since Ti is an expensive metal, the cost of the solar battery module may possibly be raised by using Ti. It is therefore preferable that the wiring member is a composite material further containing a second substance lower in electric resistance than the first substance. By combining the first member having a desired linear expansion coefficient and the second member having a desired electric resistance, a satisfactory linear expansion coefficient and a satisfactory electric resistance for the wiring member can be realized as a whole.

Examples of the composite material consisting of the first substance and the second substance may include (1) a composite material of the first substance and the second substance in a strand wire form, (2) a composite material of the flat first substance and the flat second substance, (3) a composite material having the second substance mixed into the first substance or the first substance mixed into the second substance, (4) a composite material in which the first substance having a circular cross section is covered with the second substance, and in which a circle composed by the first substance and a circle composed by an exposed surface of the second substance are substantially concentric in the cross section, and (5) a composite material obtained by alloying the first substance and the second substance.

An example of a shape of the composite material (1) may include a shape such that surroundings of the second substance are covered with a strand wire consisting of the first substance. An example of a shape of the composite material (2) may include a shape such that both surfaces of the first substance are covered with the second substance. An example of a shape of the composite material (3) may include a shape such that the first substance and the second substance are uniformly mixed together.

In each of the composite materials (1) to (5), a ratio of the first to the second substances is preferably adjusted so that the wiring member has the satisfactory linear expansion coefficient and the satisfactory electric resistance as a whole. The "satisfactory linear expansion coefficient" is a coefficient as close as possible the linear expansion coefficient of the substrate used in the solar battery cell. The "satisfactory electric resistance" is a resistance equal to or less than 80 × 10 µΩmm.

Examples of the first substance which can be used in the composite materials (1) to (5) may include Invar, Kovar (femico), other Ni-Fe alloys, W, Mo and the like. Examples of the second substance which can be used in the composite materials (1) to (5) may include Cu, Al, Ag, Au, Ti and the like. In particular, a combination of Invar and Cu is preferably used.

In each of the composite materials (1) to (4), if Invar, Cu and the silicon substrate are used, a volume ratio of Invar to Cu is preferably in a range of 1 : 0.25 to 1 : 5, more preferably in a range of 1 : 2 to 1 : 4. Within this range, the linear expansion coefficient of the wiring member can be made closer to that of the silicon substrate than Cu while keeping the electric resistance of the wiring member lower than that of Invar.

For example, the present inventors confirm the following respects. A three-layer composite material is formed by putting an Invar plate between two Cu plates. A plate thickness ratio of Cu, Invar and Cu is set at 2 : 1 : 2. An entire thickness of the composite material is set at 160 µm. The composite material can thereby exhibit substantially equal solar battery output characteristics to those of conventionally used Cu (thickness: 150 µm). The present inventors also confirm that the linear expansion coefficient of the composite material is lower than that of Cu, and that the advantage can be therefore attained. The plate thickness ratio, the plate thickness, the number of layers, an order of layers, and the like are not limited to this example.

In case of the composite material (5), if Invar, Cu, and the silicon substrate are used, a weight ratio of Invar to Cu is preferably in a range of 1 : 0.2 to 1 : 6, more preferably in a range of 1 : 2 to 1 : 4.5. Within this range, the linear expansion coefficient of the wiring member can be made closer to that of the silicon substrate than Cu while the wiring member exhibits substantially equal solar battery output characteristics to those of the conventionally used Cu.

Further, the wiring member is preferably coated with a solder. The type of the solder is not particularly limited, but any one of various solders well known in the art can be used. It is preferable to use an environment-friendly lead-free solder. At least a desired portion of the wiring member which is to be connected to the solar battery cell, e.g., an end of the wiring member is preferably coated with the solder.

Then, the present invention also provides a method for manufacturing a solar battery module using the wiring member. Specifically, the solar battery module can be manufactured by heating all of a plurality of solar battery cells in a furnace, and connecting the solar battery cells to one another by the wiring member while the solar battery cells themselves accumulate a heat.

Specifically, a thermal strain of each of the solar battery cells is minimized by performing general heating using reflow in the furnace. The wiring member cut and processed into a necessary length is press-contacted with electrode parts of the solar battery cell that accumulates the heat using a light reception surface and a rear surface of the solar battery cell, and welded with the electrode parts by the solder. The wiring member is preferably unheated so as to minimize an influence of the heat. By not heating the wiring member, it is possible to suppress the influence of the strain resulting from thermal expansion and contraction.

With this method, it is possible to realize efficient multiple effects in various aspects including an effect that the solar battery cells can be simultaneously connected in series, an effect that defects such as cracking of the solar battery cell can be reduced, an effect that an operation time can be shortened, and an effect that the number of components can be decreased.

Embodiments of the present invention will be described hereinafter with reference to the drawings. It should be noted that the present invention is not limited to these embodiments.

### (First Embodiment)

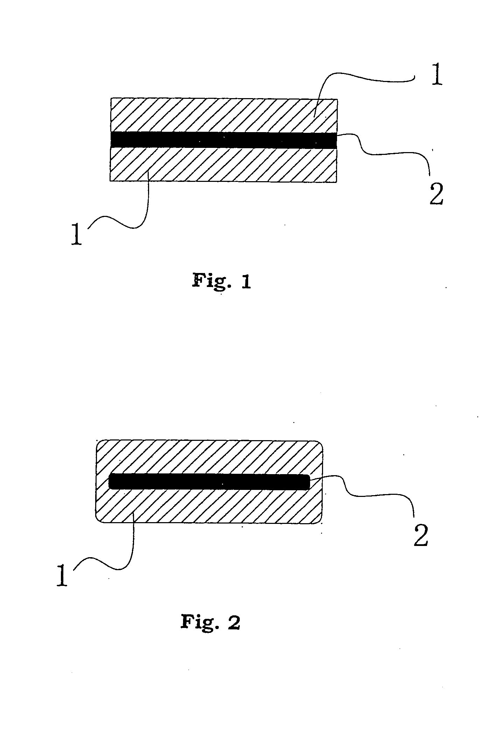

Fig. 1 is a schematic cross-sectional view of a wiring member according to a first embodiment of the present invention in a direction perpendicular to a current flow direction. The wiring member according to the first embodiment is a rectangular parallelepiped or an elliptical cone-shaped, so-called conductor having a sufficient length in a direction perpendicular to the cross-sectional view of Fig. 1. In the first embodiment, a composite material having superimposed Cu (1)/Invar (2)/Cu (1) is used for the wiring member. In the first embodiment, the composite material of Cu (1)/Invar (2)/Cu (1) at a thickness ratio of 2 : 1 : 2 is typically used. As already described, Cu may be optionally replaced by one of Au, Ag, Al, Ti and the like. Invar may be optionally replaced by one of Ni-Fe alloys having different blending ratios, Kovar, W, Mo and the like. In the first embodiment, surroundings of the wiring member are not coated with a solder. Consequently, the wiring member is used while being connected to a solar battery cell-side electrode pattern using a solder paste, ultrasonic welding or the like.

### (Second Embodiment)

Fig. 2 is a schematic cross-sectional view of a wiring member according to a second embodiment of the present invention in a direction perpendicular to a current flow direction. The wiring member according to the second embodiment is a rectangular parallelepiped or an elliptical cone-shaped, so-called conductor having a sufficient length in a direction perpendicular to the cross-sectional view of Fig. 2. In the second embodiment, a composite material having superimposed Cu (1)/Invar (2)/Cu (1) is used for the wiring member. In the second embodiment, the composite material of Cu (1)/Invar (2)/Cu (1) at a thickness ratio of 2 : 1 : 2 is typically used. As already described, Cu may be optionally replaced by one of Au, Ag, Al, Ti and the like. Invar may be optionally replaced by one of Ni-Fe alloys having different blending ratios, Kovar, W, Mo and the like.

The second embodiment differs from the first embodiment in that Invar (2) is completely covered with Cu (1). By thus completely covering Invar (2) having a low linear expansion coefficient with Cu (1) having a low electric resistance, it is possible to minimize the deterioration of the characteristics of the solar battery cell itself due to a contact resistance generated on the wiring member because of the difference in a wiring state and a contact surface. In the second embodiment, surroundings of the wiring member are not coated with a solder. Therefore, the wiring member is used while being connected to a solar battery cell-side electrode pattern using a solder paste, ultrasonic welding or the like.

### (Third Embodiment)

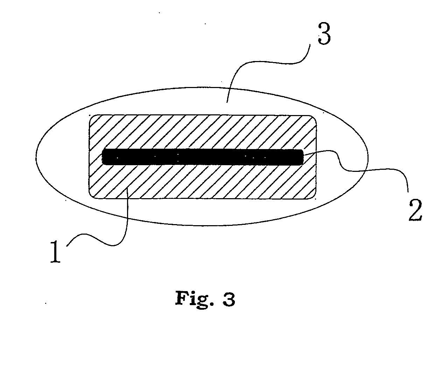

Fig. 3 is a schematic cross-sectional view of a wiring member according to a third embodiment of the present invention in a direction perpendicular to a current flow direction. The wiring member according to the third embodiment is a rectangular parallelepiped or an elliptical cone-shaped, so-called conductor having a sufficient length in a direction perpendicular to the cross-sectional view of Fig. 3. In the third embodiment, a composite material having superimposed Cu (1)/Invar (2)/Cu (1) is used for the wiring member. In the third embodiment, the composite material of Cu (1)/Invar (2)/Cu (1) at a thickness ratio of 2 : 1 : 2 is typically used. As already described, Cu may be optionally replaced by one of Au, Ag, Al, Ti and the like. Invar may be optionally replaced by one of Ni-Fe alloys having different blending ratios, Kovar, W, Mo and the like. The third embodiment is equal to the second embodiment up to these respects.

In the third embodiment, surroundings of the wiring member are coated with a lead-free solder (3) with the wiring member used as a core. In the third embodiment, therefore, by heating the wiring member, the solder on surfaces of the wiring member is molten, whereby the wiring member can be connected to the solar battery cell along a solar battery cell-side electrode pattern. Needless to say, a leaded solder may be used. In this embodiment, however, the lead-free solder is positively used so as to be able to deal with recent environmental issues.

### (Fourth Embodiment)

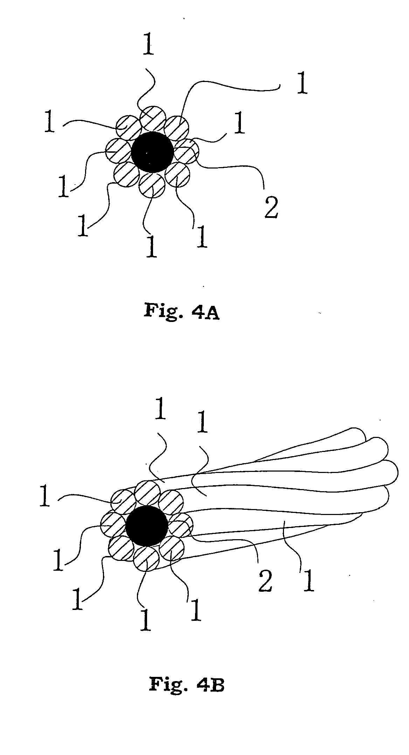

Fig. 4A is a schematic cross-sectional view of a wiring member according to a fourth embodiment of the present invention in a direction perpendicular to a current flow direction. As the wiring member, a composite material in a strand wire form in which a plurality of Cu (1) wires is twisted around an Invar (2) wire and the Invar (2) wire is covered with the Cu (1) wires is used. As already described, Cu may be optionally replaced by one of Au, Ag, Al, Ti and the like. Invar may be optionally replaced by one of Ni-Fe alloys having different blending ratios, Kovar, W, Mo and the like. Fig. 4B is a schematic perspective view of Fig. 4A. As shown in Fig. 4B, the wiring member according to the fourth embodiment is a so-called conductor having a sufficient length in a direction perpendicular to the cross-sectional view of Fig. 4A. In the fourth embodiment, a bare conductor is used. The conductor may be covered with a resin cover or the like if necessary. The wiring member according to this embodiment has a high flexibility in a bending direction particularly if the wiring member is used while being bent. Therefore, the wiring member can be applied to an instance of providing a wiring on a curved surface.

### (Fifth Embodiment)

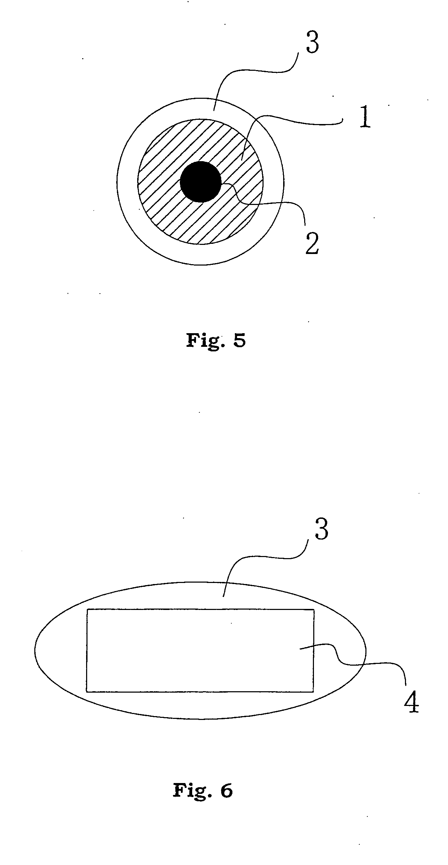

Fig. 5 is a schematic cross-sectional view of a wiring member according to a fifth embodiment of the present invention in a direction perpendicular to a current flow direction. The wiring member according to the fifth embodiment is an elliptical cone-shaped, so-called conductor having a sufficient length in a direction perpendicular to the cross-sectional view of Fig. 5. In this embodiment, a composite material in which surroundings of Invar (2) are covered with Cu (1) is used for the wiring member. As already described, Cu may be optionally replaced by one of Au, Ag, Al, Ti and the like. Invar may be optionally replaced by one of Ni-Fe alloys having different blending ratios, Kovar, W, Mo and the like. Surroundings of the wiring member are coated with a lead-free solder (3).

In the fifth embodiment, by heating the wiring member, the solder on surfaces of the wiring member is molten, whereby the wiring member can be connected to the solar battery cell along a solar battery cell-side electrode pattern. In the fifth embodiment, since the wiring member is elliptical cone-shaped, the wiring member can be easily coated with the solder at a uniform thickness. This can make it difficult to cause a partial connection defect due to bad bonding of the solder and the like. Needless to say, a leaded solder may be used. In this embodiment, however, the lead-free solder is positively used so as to be able to deal with recent environmental issues.

### (Sixth Embodiment)

Fig. 6 is a schematic cross-sectional view of a wiring member according to a sixth embodiment of the present invention in a direction perpendicular to a current flow direction. The wiring member according to the sixth embodiment is a rectangular parallelepiped or an elliptical cone-shaped, so-called conductor having a sufficient length in a direction perpendicular to the cross-sectional view of Fig. 6. In this embodiment, a composite material (4) consisting of an alloy of Invar and Cu is used for the wiring member. As already described, Cu may be optionally replaced by one of Au, Ag, Al, Ti and the like. Invar may be optionally replaced by one of Ni-Fe alloys having different blending ratios, Kovar, W, Mo and the like. By using the alloy, physical property values of Invar and Cu can be made somewhat uniform. Surroundings of the wiring member are coated with a lead-free solder (3).

In the sixth embodiment, by heating the wiring member, the solder on surfaces of the wiring member is molten, whereby the wiring member can be connected to the solar battery cell along a solar battery cell-side electrode pattern. In the sixth embodiment, since the wiring member is elliptical cone-shaped, the wiring member can be easily coated with the solder at a uniform thickness. This can make it difficult to cause a partial connection defect due to bad bonding of the solder and the like. Needless to say, a leaded solder may be used. In this embodiment, however, the lead-free solder is positively used so as to be able to deal with recent environmental issues.

### (Seventh Embodiment)

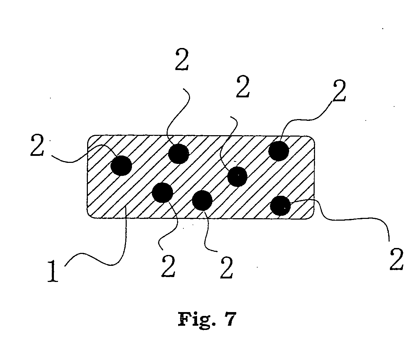

Fig. 7 is a schematic cross-sectional view of a wiring member according to a seventh embodiment of the present invention in a direction perpendicular to a current flow direction. The wiring member according to the seventh embodiment is a rectangular parallelepiped or an elliptical cone-shaped, so-called conductor having a sufficient length in a direction perpendicular to the cross-sectional view of Fig. 7. In this embodiment, a composite material having Invar (2) mixed into a Cu (1) wire is used for the wiring member. As already described, Cu may be optionally replaced by one of Au, Ag, Al, Ti and the like. Invar may be optionally replaced by one of Ni-Fe alloys having different blending ratios, Kovar, W, Mo and the like. An order of mixture can be optionally set. By adding Invar (2) to the Cu (1) wire, a flexibility of selection of blended substances can be improved, and an additive can be adjusted to an optimum amount.

In the seventh embodiment, surroundings of the wiring member are not coated with a solder. Consequently, the wiring member is used while being connected to a solar battery cell-side electrode pattern using a solder paste, ultrasonic welding or the like.

According to the present invention, by using the wiring member mainly containing the first substance which has a linear expansion coefficient close to that of the crystalline semiconductor substrate constituting the solar battery cell, the influence of the strain caused by the difference between the wiring member and the solar battery cell in thermal expansion and compression coefficient can be minimized in the wiring step which requires heating. As a result, the cracking of the solar battery cell can be reduced.

By further containing the second substance lower in electric resistance than the first substance in the composite material, it is possible to prevent an inherent function (electric conductivity) of the wiring member as the conductor from being extremely deteriorated. In other words, even if the electric resistance is increased by the first substance, the electric resistance can be reduced by including the second substance.

Since the wiring member is made of the composite material consisting of the first substance and the second substance, the irregularity between the first and the second substances can be prevented, and the wiring member can be easily handled.

Since the wiring member is made of the composite material consisting of the first substance and the second substance in the strand wire form, the irregularity between the first and the second substances can be prevented, and the wiring member can be easily handled.

Since the wiring member is made of the composite material in which the flat first substance and the flat second substance are superimposed, the irregularity between the first and the second substances can be prevented, and the wiring member can be easily handled. Further, electric characteristics of the wiring member itself can be controlled according to an order of superimposition and the number of superimposed layers. Besides, the characteristics of the respective substances that constitute the wiring member can be made effective use of in the current flow direction. Namely, the expansion and contraction of the wiring member in the current flow direction can be suppressed, and the electric resistance can be reduced. Further, the wiring member can be easily connected to a flat target, and a large connection area can be ensured.

Since the wiring member is made of the composite material obtained by alloying the first substance and the second substance, the characteristics of the respective substances can be made uniform.

Since the wiring member is made of the composite material having the second substance mixed into the first substance, the flexibility of the selection of the type of the composite material can be improved.

Since the wiring member is made of the composite material in which the both surfaces of the flat first substance are covered with the flat second substance, the linear expansion coefficient of the wiring member can be made closer to that of the solar battery cell. Therefore; this wiring member can minimize the influence of the difference between the wiring member and the solar battery cell in thermal expansion and compression coefficient in the wiring step which requires heating. As a result, the cracking of the solar battery cell can be reduced.

The wiring member is made of the composite material in which the first substance having a circular cross section is covered with the second substance, and in which a circle composed by the first substance and a circle composed by an exposed surface of the second substance are substantially concentric in the cross section. Therefore, the irregularity between the first and the second substances can be prevented, and the member can be easily handled. Further, the electric characteristics of the wiring member itself can be controlled according to the order of superimposition and the number of superimposed layers. Besides, the characteristics of the respective substances that constitute the wiring member can be made effective use of in the current flow direction. Namely, the expansion and contraction of the wiring member in the current flow direction can be suppressed, and the electric resistance can be reduced. In addition, the flat superimposition member is limited to a connection surface. However, with this wiring member, it is unnecessary to consider a surface direction of the member.

When copper is as the second substance, the electric resistance of copper is about 1.72 × 10 µΩmm, which is extremely low among all substances. Therefore, by making the composite material by superimposing Cu on the first substance, bonding Cu with the first substance, or interposing Cu between the first substances, the wiring member can attain an electric resistance comparable with that of Cu.

By coating the wiring member with the solder, the connection of the wiring member to the solar battery cell by solder welding can be facilitated. Accordingly, the highly functional wiring member can be provided.

By using the lead-free solder, the lead-containing matter is not disposed of. Therefore, the wiring member conformable with the environmental standards can be provided.

The effect of the wiring member according to the present invention can be made best use of by the ordinary reflow method in the wiring step of connecting the wiring member to each of the electrode parts provided on front and rear surfaces of the solar battery cell.

## Claims

1. A solar battery module comprising: a plurality of solar battery cells each including a crystalline semiconductor substrate; and a wiring member that connects the solar battery cells to one another, wherein the wiring member contains a first substance having a linear expansion coefficient closer to that of the substrate constituting each of the solar battery cells than Cu.

2. A solar battery module of claim 1, wherein the wiring member is further containing a second substance lower in electric resistance than the first substance.

3. A solar battery module of claim 2, wherein the wiring member is a composite material consisting of the first substance and the second substance.

4. A solar battery module of claim 3, wherein the wiring member is a composite material consisting of the first substance and the second substance in a strand wire form.

5. A solar battery module of claim 3, wherein the wiring member is a composite material of the first substance and the second substance in flat form.

6. A solar battery module of claim 2, wherein the wiring member is a composite material obtained by alloying the first substance and the second substance.

7. A solar battery module of claim 3, wherein the wiring member is a composite material having the second substance mixed into the first substance or the first substance mixed into the second substance.

8. A solar battery module of claim 5, wherein the wiring member is a composite material having a shape that all of the surfaces of the first substance are covered with the second substance.

9. A solar battery module of claim 3, wherein the wiring member is a composite material in which the first substance having a circular cross section is covered with the second substance, and in which a circle composed by the first substance and a circle composed by an exposed surface of the second substance are substantially concentric in the cross section.

10. A solar battery module of claim 2, wherein the first substance is Invar.

11. A solar battery module of claim 2, wherein the second substance is Cu.

12. A solar battery module of claim 3, wherein the crystalline semiconductor substrate is a silicon substrate, the first substance is Invar and the second substance is Cu, a volume ratio of Invar to Cu is in a range of 1 : 0.25 to 1 : 5.

13. A solar battery module of claim 6, wherein the crystalline semiconductor substrate is a silicon substrate, the first substance is Invar and the second substance is Cu, a weight ratio of Invar to Cu is in a range of 1 : 0.2 to 1 : 6.

14. A solar battery module of claim 1, wherein the wiring member is coated with a solder.

15. A solar battery module of claim 14, wherein the solder is a lead-free solder.

16. A manufacturing method of solar battery module of claim 1, comprising the steps of: heating all of a plurality of solar battery cells in a furnace; and connecting the solar battery cells to one another by a wiring member while the solar battery cells accumulate a heat.
